# EUROPÄISCHE PATENTANMELDUNG

(11) **EP 0 791 958 A1**
(43) Veröffentlichungstag der Anmeldung: **27.08.1997**
(21) Anmeldenummer: 97101700.9
(22) Anmeldetag: 04.02.1997
(51) Int. Cl.: H01L 21/77, H01L 21/78, H01L 27/02

(54) **Verfahren zum Herstellen von Halbleiterelementen mit aktiven Strukturen**

(30) Priorität: 24.02.1996 DE 19607047
(71) Anmelder: Deutsche ITT Industries GmbH, 79108 Freiburg (DE)
(72) Erfinder: Igel, Günter, Dipl.-Ing., 79331 Teningen (DE)

(57) **Zusammenfassung**

Die Erfindung betrifft ein Verfahren zum Herstellen von Halbleiterelementen 2 mit aktiven Strukturen 3, welche in einem Wafer 1 miteinander verbunden sind, wobei die Fläche eines Halbleiterelements 2 durch Verfahrensparameter bestimmt und wesentlich größer als die Fläche einer aktiven Struktur 3 ist. Eine Verbesserung des Verfahrens wird dadurch erreicht, daß auf einem Halbleiterelement 2 jeweils mehrere gleiche aktive Strukturen 3 ausgebildet werden.

## Beschreibung

Die Erfindung betrifft ein Verfahren zum Herstellen von Halbleiterelementen mit aktiven Strukturen, welche in einem Wafer miteinander verbunden sind, wobei die Fläche eines Halbleiterelements durch Verfahrensparameter bestimmt und wesentlich größer als die Fläche einer aktiven Struktur ist.

Ein solches Verfahren ist aus der Praxis bekannt. Die Mindestfläche eines Halbleiterelements wird oft durch die Verfahrensparameter bestimmt. So ist beispielsweise zwischen den Halbleiterelementen ein Toleranzbereich zu berücksichtigen, der zum Heraustrennen der einzelnen Halbleiterelemente notwendig ist. Für diesen Toleranzbereich ist eine entsprechende zusätzliche Fläche erforderlich. Nach dem Heraustrennen müssen die einzelnen Halbleiterelemente transportiert werden, d.h. sie müssen mechanisch handhabbar sein. Hierzu wird z.B. nach dem Trennvorgang ein Halbleiterelement aus dem Wafer herausgenommen und auf einen Systemträger (lead frame) aufgesetzt und auf diesem durch Chipbonden, beispielsweise durch Kleben oder Löten befestigt. Dabei ist eine Mindestgröße der Halbleiterbauelemente erforderlich, die in vielen Fällen die Fläche eines Halbleiterbauelements mitbestimmt. Es gibt viele Anwendungsbeispiele, in denen die aktive Struktur, die auf ein solches Halbleiterbauelement aufgebracht wird, wesentlich kleiner als die Fläche des Halbleiterelements ist, die zur mechanischen Handhabung notwendig ist. Dies führt dazu, daß das Herstellungsverfahren der Halbleiterelemente teuer wird, da ein erheblicher Anteil des Halbleitermaterials nicht für die eigentliche Funktion des Halbleiterelements genutzt wird. Die Herstellungskosten werden weiter dadurch erhöht, daß die aktiven Strukturen oft mit Fehlern behaftet sind. Dies kann durch Testen der aktiven Strukturen festgestellt werden. Fehlerhafte Strukturen oder Strukturen, die den vom Anwender gestellten Anforderungen nicht genügen, werden üblicherweise mit einer farbigen Tinte gekennzeichnet und nicht auf den Systemträger aufgebracht. Nach dem Aufbringen auf den Systemträger werden die Halbleiterelemente üblicherweise einem Drahtbonder zum Kontaktieren der aktiven Strukturen zugeführt.

Der Erfindung liegt die Aufgabe zugrunde, das gattungsgemäße Verfahren so zu verbessern, daß die Halbleiterbauelemente billiger hergestellt werden können.

Die Aufgabe wird dadurch gelöst, daß auf einem Halbleiterelement jeweils mehrere gleiche aktive Strukturen ausgebildet werden. Hierdurch wird die Fläche des Halbleiterelements effektiv ausgenutzt. Wenn die auf einem Halbleiterbauelement aufgebrachten aktiven Strukturen getestet werden, kann die für die jeweilige Anwendung geeigneteste Struktur ausgewählt und verwendet werden. Die Wahrscheinlichkeit, daß ein Halbleiterelement nicht verwendet werden kann, nimmt mit der Anzahl der auf ihm angebrachten aktiven Strukturen ab. Somit wird die Ausbeute der Halbleiterelemente, der die vorgegebenen Anforderungen genügen, wesentlich erhöht. Die Kosten beim Herstellen der Halbleiterbauelemente sinken erheblich. Die Vorteile werden bereits dann erzielt, wenn die Fläche der Halbleiterelemente aufgrund der Verfahrensparameter wenigstens doppelt so groß wie die Fläche der aktiven Strukturen ist. Bei den aktiven Strukturen handelt es sich um im wesentlichen gleiche Strukturen.

Gemäß einer günstigen Weiterbildung der Erfindung wird eine aktive Struktur des jeweiligen Halbleiterelements kontaktiert. Die Fläche des Halbleiterelements die zum Kontaktieren notwendig ist, beispielsweise durch Drahtbonden, ist in der Regel deutlich kleiner als die zur Handhabung der Halbleiterelemente erforderliche Fläche. So ist bei der heutigen Technologie zum mechanischen Transportieren eines Halbleiterelements eine Kantenlänge von 250 µm erforderlich, wohingegen zum Drahtbonden lediglich eine Kanten- bzw. Strukturlänge von 50 µm erforderlich wäre. In diesem Fall könnten 25 aktive Strukturen auf ein Halbleiterelement aufgebracht werden. Wenn eine davon verwendet und kontaktiert wird, wird die Wahrscheinlichkeit, daß das Halbleiterelement für die vorgesehene Funktion verwendet werden kann, entsprechend der Multiplikation der Wahrscheinlichkeiten erhöht.

Es ist vorteilhaft, wenn wenigstens ein physikalischer Parameter der aktiven Strukturen gemessen wird, und aus dem Meßergebnis bestimmt wird, welche aktive Struktur eines Halbleiterelements kontaktiert wird. Dies ermöglicht einen Vergleich der Strukturen untereinander, so daß die beste Struktur für die jeweiligen Anwendungsbedingungen ermittelt werden kann. Auch ist es günstig, wenn die physikalischen Parameter jeweils mit einer der aktiven Struktur eineindeutig zugeordneten Größe gespeichert werden, die Parameter mit vorgegebenen Werten verglichen werden, und aus diesem Vergleich bestimmt wird, welche aktive Struktur eines Halbleiterelements kontaktiert wird. Hierdurch kann für jedes Halbleiterelement das aktive Element ausgesucht werden, das den vorgegebenen Parametern am nächsten kommt.

Es können auch die physikalischen Parameter jeweils mit einer der aktiven Struktur eineindeutig zugeordneten Größe gespeichert werden, die Parameter der aktiven Strukturen eines Halbleiterelements mit den Parametern der anderen aktiven Strukturen wenigstens eines anderen Halbleiterelements verglichen werden, und aus diesem Vergleich bestimmt werden, welche aktive Struktur ein Halbleiterelement kontaktiert wird. So können aktive Strukturen der Halbleiterelemente ermittelt werden, die beispielsweise gleiche Parameter haben und somit gleichen Anforderungen genügen. Bevorzugterweise können die aktiven Strukturen elektronische Strukturen und die physikalischen Parameter elektrische Größen sein. Das erfindungsgemäße Verfahren ist aber auch auf alle anderen aktiven Strukturen, beispielsweise optische, elektrooptische, magnetische Strukturen, Sensoren und ähnliches anwendbar.

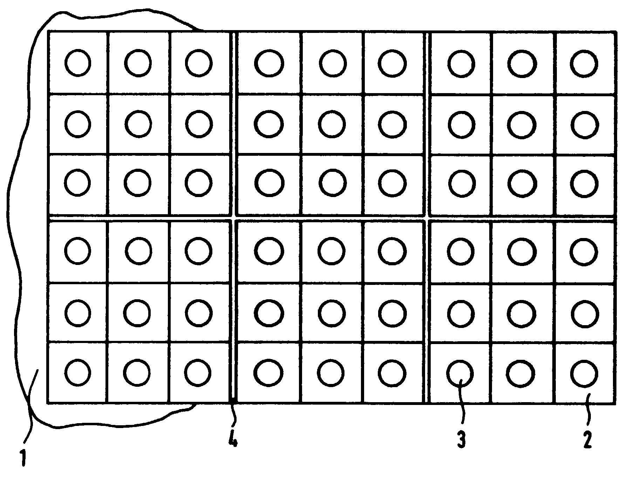

Im folgenden wird die Erfindung anhand der Zeichnung erläutert.

Die Figur zeigt einen Ausschnitt aus einem Wafer 1 mit Halbleiterelementen 2. Der gezeigte Ausschnitt des Wafers 1 enthält 6 Halbleiterelemente 2. Auf jedem dieser Halbleiterelemente 2 sind 6 aktive Strukturen 3 vorgesehen. Dabei gleichen die aktiven Strukturen 3 einander. Zwischen den Halbleiterelementen 2 sind Trennbereiche 4 vorgesehen. Auf die Trennbereiche 4 können keine aktiven Strukturen 3 aufgebracht werden, da diese zum Trennen der Halbleiterelemente 2 aus dem Wafer 1 erforderlich sind. In den Trennbereichen wird beispielsweise durch Sägen Material abgetragen.

In dem gezeigten Beispiel werden statt einer aktiven Struktur 3 neun aktive Strukturen 3 auf ein Halbleiterelement 2 aufgebracht. Das Aufbringen solcher aktiven Strukturen erfolgt nach herkömmlichen Verfahren durch eine für die jeweilige Struktur erforderliche Abfolge von Maskierungs-, Photolackbeschichtungs-, Belichtungs-, Ätz-, Dotierungs- und Beschichtungsverfahren. Die Anzahl dieser Schritte bleibt beim Aufbringen von mehreren aktiven Strukturen 3 auf die Halbleiterelemente 2 unverändert, so daß in dieser Hinsicht kein technischer Mehraufwand erforderlich ist. Ein typisches Anwendungsbeispiel sind elektronische Elemente, wie diskrete Halbleiterelemente oder kleine IC-Elemente. Die einzelnen aktiven Stukturen 3 der Halbleiterelemente 2 werden, meist auf dem Wafer, getestet. Elektronische Elemente müssen häufig besonderen elektrischen Anforderungen genügen. Hierzu können die erforderlichen elektrischen Parameter gemessen werden. Es kann entweder sofort durch einen Vergleich bestimmt werden, welche der aktiven Strukturen 3 eines jeden Halbleiterelements 2 verwendet werden soll. Es können auch die elektrischen Parameter gespeichert und mit entsprechenden Bezugswerten, entweder vorgegebenen Parametern oder Werten der aktiven Strukturen 3 der anderen Halbleiterelemente 2, verglichen werden. Erforderlich ist dabei, daß mit den gemessenen Paramtern eine der jeweiligen aktiven Struktur eineindeutig zugeordnete Größe gespeichert wird, aus welcher sich der Ort der aktiven Struktur 3 auf dem Halbleiterbauelement 2 bestimmen läßt. Die Halbleiterelemente 2 werden nach einem herkömmlichen Verfahren aus dem Wafer 1 herausgetrennt und beispielsweise auf einen Systemträger aufgebracht. Sie können auf diesem beispielsweise durch Bonden befestigt werden. Danach werden die Halbleiterelemente 2 beispielsweise einem Drahtbonder zugeführt, wo die aktiven Strukturen 3, die gemäß den Meßergebnissen verwendet werden sollen, kontaktiert werden.

## Patentansprüche

1. Verfahren zum Herstellen von Halbleiterelementen (2) mit aktiven Strukturen (3), welche in einem Wafer (1) miteinander verbunden sind, wobei die Fläche eines Halbleiterelements (2) durch Verfahrensparameter bestimmt und wesentlich größer als die Fläche einer aktiven Struktur (3) ist, dadurch gekennzeichnet, daß auf einem Halbleiterelement (2) jeweils mehrere gleiche aktive Strukturen (3) ausgebildet werden.

2. Verfahren nach Anspruch 1, dadurch gekennzeichnet, daß eine aktive Struktur (3) des jeweiligen Halbleiterelements (2) kontaktiert wird.

3. Verfahren nach einem der vorangehenden Ansprüche, dadurch gekennzeichnet, daß wenigstens ein physikalischer Parameter der aktiven Strukturen (3) gemessen wird, und aus dem Meßergebnis bestimmt wird, welche aktive Struktur (3) eines Halbleiterelements (2) kontaktiert wird.

4. Verfahren nach Anspruch 3, dadurch gekennzeichnet, daß die physikalischen Parameter jeweils mit einer der aktiven Struktur (3) eineindeutig zugeordneten Größe gespeichert werden, die Parameter mit vorgegebenen Werten verglichen werden, und aus diesem Vergleich bestimmt wird, welche aktive Struktur (3) eines Halbleiterelements (2) kontaktiert wird.

5. Verfahren nach Anspruch 3, dadurch gekennzeichnet, daß die physikalischen Parameter jeweils mit einer der aktiven Struktur (3) eineindeutig zugeordneten Größe gespeichert werden, die Parameter der aktiven Strukturen (3) eines Halbleiterelements (2) mit den Parametern der anderen aktiven Strukturen (3) wenigstens eines anderen Halbleiterelements (2) verglichen werden, und aus diesem Vergleich bestimmt wird, welche aktive Struktur (3) eines Halbleiterelements (2) kontaktiert wird.

6. Verfahren nach einem der vorangehenden Ansprüche, dadurch gekennzeichnet, daß die aktiven Strukturen (3) elektronische Strukturen und die physikalischen Parameter elektrische Größen sind.
